# EUROPEAN PATENT APPLICATION

(11) **EP 4 636 477 A1**
(43) Date of publication of application: **22.10.2025**
(21) Application number: 24171157.1
(22) Date of filing: 18.04.2024
(51) Int. Cl.: G03F 1/24, G03F 1/72

(54) **EUV CD CONTROL BY MODIFICATION OF ML REFLECTIVITY USING LASER TREATMENT**

(71) Applicant: Carl Zeiss SMS Ltd., 2015600 Misgav (IL)
(72) Inventor: GUSAROV, Alexander, 2015600 Misgav (IL); COHEN, Avi, 2015600 Misgav (IL); OSHEMKOV, Sergey, 2015600 Misgav (IL); SCHERUEBL, Thomas Franz Karl, 2015600 Misgav (IL); DMITRIEV, Vladimir, 2015600 Misgav (IL)
(74) Representative: Bardehle Pagenberg Partnerschaft mbB Patentanwälte Rechtsanwälte

(57) **Abstract**

A method for treating a multilayer system of an extreme ultraviolet photolithography mask, the method comprises providing a first pulsed laser irradiation with at least one first pulse parameter, providing a second pulsed laser irradiation with at least one second pulse parameter, and directing the first pulsed laser irradiation and the second pulsed laser irradiation into and/or onto the multilayer system, wherein the first pulsed laser irradiation and the second pulsed laser irradiation differ in a refelctivity change (δR) / registration change (δREG) ratio induced in the EUV photolithography mask.

## Description

### 1. Technical Field

The present invention relates to methods, apparatuses, and computer programs for treating a multilayer system of an extreme ultraviolet (EUV) photolithography mask.

### 2. Background

With ever-decreasing dimensions of feature sizes e.g., on silicon wafers, corresponding lithographic masks, etc., extremely short wavelengths are required to reach the intended level of resolution. For example, EUV lithography (e.g., at a wavelength of 13.5 nm) plays an important role in providing such small features. While the short wavelength allows for an increased resolution, essential for the manufacturing requirements, on the one hand, it also introduces critical complications on the other hand: For example, the reflectance of single metallic surfaces is negligible for these wavelengths, which is why conventional mirrors (e.g., silver (Ag) or gold (Au) mirrors) are not applicable in such applications.

EUV photolithography masks often comprise multilayer systems, e.g., of alternating Mo/Si layers. These multilayer systems may act as suitable as EUV mirrors (e.g., for wavelengths of and around 13.5 nm). These multilayer systems typically comprise a periodic alternating arrangement of two materials with a significantly different index of refraction (e.g., molybdenum (Mo) and silicon (Si)). This corresponds to a Bragg mirror, in which constructive interference may be achieved for a certain angle of incidence and a required wavelength range (e.g., in the EUV). Mo/Si multilayers with additional diffusion barriers at selected interfaces have demonstrated a reflectance of 70% or more. The layer thickness required for high near-normal incidence reflectance at 13.5 nm wavelength is in the nanometer range to achieve constructive interference with ca. 50 multilayer periods.

In reality, such multilayer systems are no perfect reflectors. E.g., their interfaces are not chemically abrupt which may result in a diminished optical contrast and consequently to lower reflectance at the respective interface. Imperfections at the (e.g., Mo/Si) interfaces (e.g., resulting from interdiffusion, compound formation, and/or roughness) and unavoidable absorption are the main reasons for said losses.

For photolithography masks, the homogeneity of the optical transmission and/or reflection across the mask area is decisive. A variation thereof over the area of the photolithography mask leads to a corresponding variation of the local optical dose applied to the photoresist placed on the wafer. The variation of the locally applied dose results in a fluctuation or variation of the pattern dimensions of a pattern element in the developed photoresist. The uniformity of a pattern element across the area of the photolithographic mask is called critical dimension uniformity (CDU). Thus, there exist methods for treating and/or modifying EUV photolithography masks, in particular their multilayer systems in order to correct imperfections thereof. These aim at realizing small variations of reflectivity, expressed as a reflectivity change (δR). Depending on the terminology, one may analogously refer to a critical dimension change δCD, in this context instead.

In general, present methods for treating and/or modifying such EUV photolithography masks, e.g., comprising multilayer systems, still yield various challenges. Typically, the collateral damage that comes along with treatments of multilayer systems for CD control, is a multilayer system compaction. This effect is limiting applicability of multilayer system CD control. For example, some methods rely on illuminating the multilayer systems from the backside (i.e., the side with no absorber material) in order to prevent substantial influence of the absorber pattern load/density on the illumination intensity passing the absorber layer (as observed in frontside illumination). The same treatment of layers closer to the absorber pattern, e.g., by frontside illumination, may result in higher reflectivity suppression on the one hand, but on the other hand, it yields disadvantages compared to backside illumination.

E.g., backside processing may, e.g., be selected due to its immunity to the absorber pattern load. In detail, an incoming illumination in an area of the multilayer system with a densely packed absorber pattern may be attenuated strongly while in less densely packed areas, it may be attenuated less. Thereby, the effective illumination intensity for multilayer system treatment may vary depending on the position of the multilayer system which may make the process less reproducible, accurate, and/or controllable.

However, in backside illumination, the modification of the optical element requires high intensities and may be accompanied with high intensity-related unwanted side effects: E.g., this process typically suffers from the high induced multilayer system compaction and a resulting registration impact. Therein, the absorber elements of the absorber pattern may be dislocated due to the uneven compaction of the multilayer system. This is a critical drawback as it may decrease the quality of the EUV photolithography mask in the contrary to the purpose of the method, namely correcting imperfections rather than introducing even further imperfections.

Often, further approaches are utilized, e.g., configured to modify an expansion of the substrate, e.g., to compensate for backside-illumination-induced registration. However, such substrate-modifications typically achieve a resolution in the range of ca. 500 µm which is often too coarse for realizing the target resolution.

Therefore, there is still a need to improve methods, apparatuses, and computer programs for treating a multilayer system of an extreme ultraviolet (EUV) photolithography mask.

### 3. Summary

The invention solves the above problems at least in part.

A first aspect of the present invention relates to a method for treating a multilayer system of an EUV photolithography mask, the method comprising: providing a first irradiation, preferably a first pulsed laser irradiation, with at least one first (e.g., pulse) parameter, providing a second irradiation, preferably a second pulsed laser irradiation, with at least one second (e.g., pulse) parameter, and directing the first irradiation and the second irradiation into and/or onto the multilayer system. Therein, the first irradiation and the second irradiation differ in a reflectivity change (δR) / registration change (δREG) ratio induced in the EUV photolithography mask.

The inventors found that it is particularly advantageous to combine two irradiations with different δR/δREG ratios. This allows targeting a certain δR by adjusting the use of the two respective irradiations such that the total achieved δREG can be controlled as well, e.g., over a certain area of the EUV photolithography mask such as to suppress δREG effects that deteriorate the quality of the EUV lithography mask. Also, the ratio may be adjusted locally, such as to achieve a simultaneous optimization of δR and δREG.

Thereby, better resolutions than with the conventional methods, e.g., as described herein, can be achieved and higher over-all qualities of the EUV photolithography masks can be achieved. The inventive way of treating the EUV photolithography mask can result in deeper reflectivity drops and/or less compaction/registration.

The first and/or second (pulse) parameter may also indicate that the irradiation is a continuous (e.g., continuous wave (CW)) irradiation, i.e., such that it comprises no pulses as such. The same applies to a third irradiation described herein.

Herein, an "irradiation" can preferably be a pulsed and/or laser irradiation. Any irradiation described herein may comprise a laser irradiation, a pulsed laser irradiation, and/or other types of pulsed or continuous irradiations, e.g.: a particle irradiation (e.g., comprising charged particles, electrons, protons, and/or ions).

In some examples, the first (pulsed laser) irradiation comprises a relatively high δR/δREG ratio, preferably in the range from 0.2% to 1% reflectivity drop per ppm registration change; and the second (pulsed laser) irradiation comprises a relatively low δR/δREG ratio, preferably below 0.2% reflectivity drop per ppm registration change.

The inventors found that using one such high and one such low ration allows to fully exploit the inventive approach described herein, wherein a hybrid control of δR and δREG is allowed for as described herein.

In some examples, the first (pulsed laser) irradiation may comprise a plurality of pulse sequences, each pulse sequence comprising a plurality of pulses; wherein a first pulse and a second pulse of the plurality of pulses are separated by a time of 100 ns or less.

The inventors realized that one underlying problem exacerbating modifications of EUV photolithography masks relates to the following: When processing an optical element using a laser to change the reflectivity in certain areas of the optical element, unwanted displacements of structures on the surface of the optical element may be generated, as the energy input into the energy input into the stack shifts it in the direction of the laser irradiation.

The inventors further found that introducing femtosecond laser pulses as pulse sequences into the optical element, whereby the energy input may be variable over nanoseconds, at least reduces the unwanted displacement of structures (e.g., absorber material) on the optical element. This discovery is based on the understanding of the underlying physical processes following absorption of light (of the laser irradiation) within the optical element: The absorption of laser energy by free electrons and energy exchange of electrons at a rate of υₑₑ ~ 10¹⁴ s⁻¹ raises the electron temperature Tₑ to ca. 10,000 K while, initially, the lattice temperature of the optical element Tᵢ remains at ca. 300 K, when the optical element is at room temperature. Subsequently, the electrons transfer their energy to the lattice with a rate of υₑᵢ z; 10¹² S⁻¹, which translates to ca. 1 ps. This is the specific time of metal heating. The absorbed energy then dissipates within the material according to the thermal diffusion coefficient of the material composition of the optical element. As described herein, typical optical elements may, e.g., comprise Mo and Si with diffusion coefficients D_{Mo} = 0.54 cm²/s and D_{Si} = 0.88 cm²/s. The diffusion (described by the equation t ~ L₂/D) thus typically occurs on longer timescales than 1 ps for diffusion lengths L of 7 nm or more. The invention accounts for the relevance of the different timescales of the underlying physical processes as described herein:
Especially, the first and second pulse being separated by a time of 100 ns or less proved to allow for improved results in modification of the optical element. Keeping the time between the pulses sufficiently short may allow to induce (thermal) energy of the second pulse into the optical element shortly after the first pulse when the treated optical element has not yet thermally equilibrated (e.g., via thermal diffusion). In detail, experiments with a pulse sequence comprising two pulses could achieve a 50% higher temperature at 200 nm depth within the optical element than in a control experiment with only one pulse (i.e., no pulse sequence) at essentially the same level of damage (e.g., comprising compaction and/or unwanted shifts of absorber elements thereon), and thus the effect reaches more deeply into the treated surface. Further experiments and test simulations shows that even better results can be achieved by providing longer pulse sequences. In detail, longer pulse sequences may comprise three, four, five, or more pulses, e.g., in each pulse sequence.

In particular, such first irradiation may yield a high δR/δREG ratio which, when combined with a second and/or third irradiation as described herein, may yield the advantages described herein in reference to using irradiations with different δR/δREG ratios.

Generally, a pulse sequence may be understood as a plurality of pulses, wherein the time between two consecutive pulses is less than 100 ns. Vice versa, two pulses that are temporally apart by 100 ns or less may be seen as comprised in the same pulse sequence. Typically, the time between two consecutive pulse sequences is at least three-times longer than the duration of the pulse sequence. In an example wherein the pulse sequences are emitted at a frequency of 100 kHz (which corresponds to a period of 10 µs), the pulses of one pulse sequence may lie within a time window of 100 ns and the time between consecutive pulse sequences may be at least 900 ns. In other examples, however, it is also possible that the pulses of a pulse sequence have a longer separation time, e.g., above 100 ns.

The EUV wavelength range may, e.g., comprise wavelengths between 10 nm and 121 nm, preferably between 10 nm and 20 nm, more preferably between 10 nm and 15 nm.

Herein, a pulse sequence may comprise two or more pulses, each pair of which may be identical or vary in at least one pulse parameter. The at least one pulse parameter may comprise, e.g., a pulse length (e.g., expressed through the full width half maximum of the pulse), an intensity (e.g., expressed through the maximum amplitude of the pulse and/or the total energy of the pulse), a temporal pulse shape (e.g., an essentially Gaussian shape, a triangular shape, etc.), and/or a spatial pulse shape (e.g., a pulse cross section comprising a two-dimensional gaussian distribution or any other regular or unregular shape).

Typically, the pulses of the pulse sequence may be essentially (temporally) equidistant. The pulses of the pulse sequences may be emitted at a certain frequency and/or in a non-periodic (temporal) pattern.

In some examples, the same pulse sequence may be repeated at a certain frequency, e.g., at a frequency of 100 kHz (which corresponds to a period of 10 µs), for a predetermined time.

In some examples, the second (pulsed laser) irradiation may comprise an essentially continuous and/or periodic pulse train (i.e., no pulse sequence like the first (pulsed laser) irradiation may comprise).

The inventors found out that this may be an option to realize different δR/δREG ratios of the first and second (pulsed laser) irradiation.

In some examples, the first pulse and the second pulse of the plurality of pulses may be separated by a time of at least 10 ns.

The inventors found that typical EUV photolithography masks, e.g., comprising Mo-Si multilayer systems as described herein, have high absorption coefficients. Thus, laser irradiation used to modify the optical element is typically absorbed mostly at and near the irradiated surface of the irradiated optical element. Thus, deeper depths may not be predominantly treated directly be the laser irradiation but rather by thermal diffusion driven processes. However, deep depths may not always be reached. Especially when femtosecond laser pulses are utilized. In order to exploit the advantages of reduced side effects associated with such femtosecond laser pulses on the one hand but also treating deep depths of the optical element on the other hand, the inventors identified the importance of tailoring the sequence duration. E.g., for equidistant pulses (separated by a time interval Δt), the duration of a pulse sequence comprising n pulses, the duration of the pulse sequence may amount to (n-1)·Δt.

In detail, providing pulse sequences that are sufficiently long (e.g., 10 ns or more) could increase the temperature in deep depths of the optical element (e.g., at 200 nm depth) relative to the temperature reached at the irradiated surface of the optical element by more than an order of magnitude.

In some examples, the pulses of the plurality of pulses may be repeated at a frequency of 10 MHz to 1 GHz.

Such high (intra-sequence) repetition rate was shown to yield various advantages. On the one hand, such sequences may be provided with high accuracy and reliability. On the other hand, the high repetition rate (and thus the short times between consecutive pulses) is high enough (or short enough, respectively) to be on the same timescale as the underlying physical processes (e.g., heat diffusion within the optical element on the relevant length scales). Thus, one may optimize the efficiency of the treatment and/or modification of the optical element associated with said underlying physical processes.

Such pulse sequences may, e.g., be provided by a laser source comprising a so-called burst mode laser. The laser source may, e.g., comprise a Q-switched laser and/or a continuously operating mode-locked laser (e.g., as described herein). Such laser sources may, e.g., further comprise a pulse picker, an optical modulator with a continuously variable transmissivity, and/or an optical amplifier. In detail, for providing short pulses with a high repetition rate, the laser source (e.g., comprising a mode-locked laser) may further comprise a pulse splitter, which may be configured to convert a pulse emitted by the laser source into a sequence of pulses (e.g., 2, 4 or 8 pulses).

In some examples, at least one of the pulses may comprise at least one sub-sequence comprising a plurality of sub-pulses. For example, a first sub-pulse and a second sub-pulse of the plurality of sub-pulses may be separated by a time between 1 ps and 100 ns, preferably between 10 ps and 10 ns, more preferably between 100 ps and 1 ns.

By providing a sequence of pulses, wherein at least one of the pulses comprises another sub-sequence of pulses, the advantageous effects described herein may be further improved. In detail, the optical element may be treated even more efficiently while keeping the total energy deposited into the material (and potentially leading to negative side effects like compaction) low.

In some examples, the sub-pulses of the plurality of sub-pulses may be repeated at a frequency of 1 GHz to 100 GHz, preferably of 1 GHz to 10 GHz.

Such embodiments yield the advantages described herein with reference to the pulse sequences.

In some examples, the first and/or the second pulse parameter may comprise a penetration depth into the multilayer system and/or a temporal pulse pattern. For example, the first (pulsed laser) irradiation and/or the second (pulsed laser) irradiation may comprise a temporal pulse pattern.

For example, the first (pulsed laser) irradiation may have a deeper penetration depth into the multilayer system than the second (pulsed laser) irradiation. This may be achieved by realizing the first and/or second (pulsed laser) irradiation as described herein. Further, DE 10 2011 078 927 A1, which is incorporated herein by reference, describes a method for correcting a plurality of defects on a photolithography mask. The second (pulsed laser) irradiation described herein may comprise the features described in DE 10 2011 078 927 A1.

For example, the first (pulsed laser) irradiation may comprise a plurality of pulse sequences with a certain succession (e.g., defined in time and intensity) of laser pulses and/or the second (pulsed laser) irradiation may comprise a pulse train with essentially always the same time between and/or essentially the same intensity of two subsequent laser pulses of the second (pulsed laser) irradiation.

The inventors could show that these parameters proved particularly useful for achieving sufficient differences between the δR/δREG ratios of the first and second (pulsed laser) irradiation. It is noted that instead of different δR/δREG ratios, also different pulse parameters and/or penetration depths and/or numbers of affected layers of the multilayer system could be used to characterize the difference between first and second (pulsed laser) irradiation.

In some examples, the first (pulsed laser) irradiation may be adapted to substantially locally change at least two layers of the multilayer system. For example, in a multilayer system with alternating layers, an integrity of not only the first double-layer, but also that of the second double-layer may be substantially affected. For example, these may be locally changed such that there is no substantial difference of the index of refraction in these layers (e.g. an existing refractive index difference may be substantially reduced). Additionally or alternatively, the second (pulsed laser) irradiation may be adapted to substantially locally change less layers of the multilayer system than changed by the first (pulsed laser) irradiation.

In some examples, a wavelength of the first and/or second (pulsed laser) irradiation may be between 400 and 1500 nm, preferably between 700 nm and 1100 nm.

Working in this wavelength range is advantageous in various aspects: On the one hand, many substrates (e.g., comprising quartz) and/or coatings (e.g., comprising tantalum boride TaB) that may be used for optical elements as described herein are typically sufficiently transparent for the indicated wavelength ranges. This allows for treatment of the parts of the optical element in transmission through such substrates and/or coatings. On the other hand, there are various laser sources that may provide high-quality laser irradiation in this wavelength range and may be available at low costs. In one example, a titanium-sapphire laser (i.e., Ti:Al₂O₃ lasers) being a tunable laser emitting red and near-infrared laser irradiation in the range from ca. 650 nm to 1100 nm, may be used for the methods and apparatuses described herein.

For example, the repetition rate of the first and/or second (pulsed laser) irradiation may be between 1 kHz and 1 MHz, preferably between 50 kHz and 200 kHz, and/or a laser pulse length of the first and/or second (pulsed laser) irradiation may be in the femtosecond range, preferably between 10 fs and 1000 fs, more preferably between 80 fs and 300 fs.

As absorption of laser energy by free electrons occurs at a rate of υₑₑ z; 10¹⁴ s⁻¹, which translates to ca. 10 fs, it is particularly advantageous to use femtosecond laser pulses as these allow for localized heating.

These pulse parameters may, e.g., be achieved by laser sources comprising mode-locked oscillators. These may generate ultrashort pulses with the above pulse length. The repetition rate may, e.g., be determined by the round-trip optical path of the laser source, e.g., a titanium-sapphire laser as described herein. Thereby, such laser irradiation may be provided in a relatively cheap and reliable way one the one hand. On the other hand, the inventors found that providing short pulses as described herein allows to reduce unwanted side effects that are commonly observed in control experiments with longer laser pulses (e.g., in the nanosecond range). Providing both, sufficiently short pulses and sufficiently high repetition rates allow to avoid such side effects while keeping the working times sufficiently short.

In some examples, a pulse energy of the first and/or second (pulsed laser) irradiation may be between 0,05 µJ to 5 µJ. For example, a pulse density of the first and/or second (pulsed laser) irradiation may be between 1,000 pulses per mm² to 10,000,000 pulses per mm².

Such pulse energies and/or pulse densities were found to be a particularly advantageous setting in which a balance between sufficient effects onto the multilayer system are achieved while keeping the administered dose low/controlled enough that no unwanted damage occurs within the multilayer system.

For example, the method may further comprise providing a third irradiation, preferably a laser irradiation, and directing the third irradiation onto and/or into the substrate. Said third irradiation may, e.g., be configured to induce an expansion of the substrate, e.g., at and/or around the focus region of the third irradiation.

The method may, in some examples, further comprise controlling the third irradiation such the EUV photolithography mask is processed to be substantially flat.

The inventors could show the following in their experiments: Firstly, the flatness that may be achieved by the invention may be based on the exact requirements for the specific EUV photolithography mask. Nevertheless, flatness of less than 60nm, preferably of less than 30 nm (e.g., expressed as a peak-to-valley (P-V) flatness, excluding a bow). An ASML spec for the value of the final flatness typically is < 250 and 30 P-V (and may depend on a pattern pitch). The flatness improvement/control described herein may achieve < 100 < 20 P-V.

Such flatness control may significantly improve the overall mask quality and may, e.g., comprise the sub-steps described herein (e.g., below):
The third irradiation, may, e.g., be focused onto and/or into the substrate to create an energy density at and/or around its focus region that lies above an, e.g., substrate-specific, threshold. In the volume that experiences an above-threshold energy density, the substrate material may expand due to chemical and/or physical processes triggered by the high energy density. The third irradiation may, e.g., be performed with a pulse time of less than or equal to about 1 ms. The third irradiation may be performed with a pulse energy of less than or equal to about 10 mJ. Generally, the flatness control may, e.g., be performed as described in WO 2015/144700 A2 which is herewith incorporated by reference.

It can be assumed that a substrate essentially has a planar shape with two large essentially parallel surfaces, i.e., a first and a second surface. When the focus of the third irradiation is chosen to be near the first surface, the substrate may bend towards the second surface due to the induced expansion and vice versa. When the focus of the third irradiation is chosen to be essentially in the middle between the two surfaces, the induced expansion may result in a local bending of the respective surfaces near the focus point but essentially no bending of the substrate as a whole. Thus, by choosing the position of the focus, a simultaneous REG and flatness control can be realized via the third irradiation. Advantageously, substrates, that may not be perfectly flat can be bent to become flattened and/or surface variations can be compensated thereby.

This allows to further improve the quality of the EUV photolithography mask.

The method may, e.g., further comprise controlling the first and/or the second (pulsed laser) irradiation such that for a target overall δR, an overall induced δREG is controlled to lie within a predetermined range. The predetermined δREG range may comprise δREG of 0.1 nm or less.

The method may in some examples achieve a CD uniformity of 0.3 nm or less.

Vice versa, the method may comprise controlling the first and/or the second (pulsed laser) irradiation such that for a target overall δREG, an overall induced δR is controlled to lie within a predetermined range. The predetermined δR range may be such that a δCD of 0.1 nm or less may be achieved, e.g., while δREG may be below 0.5 nm.

Controlling the first and/or second (pulsed laser) irradiation may comprise controlling (i.e., varying and/or keeping constant, depending on the current requirements) a pulse energy, an intensity, a number of pulses per pulse sequence (and/or per sub-sequence), and/or an envelope (of the pulse sequence), the sub-sequence, and/or the pulse train. The same may apply analogously to the third irradiation described herein.

In a symmetric fashion, the method may, e.g., comprise setting the relative intensity/strength of the first (pulsed laser) irradiation and the second (pulsed laser) irradiation such as to set the overall induced δR and the overall induced δREG to achieve a predetermined target overall δR and a predetermined target overall induced δREG.

The induced targets described herein may be ranges (e.g., as described herein).

These approaches allow for a well-adjusted modification of the EUV photolithography mask.

In some examples, the multilayer system may comprise a frontside and a backside. Optionally, the EUV photolithography mask may comprise an absorber layer at the frontside and/or a substrate on the backside. E.g., the directing the first and second (pulsed laser) irradiation onto and/or into the multilayer system may comprise directing the first and/or second (pulsed laser) irradiation onto the backside of the multilayer system. In some examples, directing the third irradiation onto and/or into the multilayer system may comprise directing the third irradiation onto the backside of the multilayer system.

Backside irradiation may be advantageous as the radiation dose does not depend on the absorber pattern density which may result in a more reliable modification of the multilayer system. However, there may be exemplary situations, wherein it may be preferred to use frontside irradiation (e.g., for the first, second, and/or third irradiation), e.g., in scenarios with an essentially homogeneous absorber pattern density on the EUV photolithography mask.

In some examples, the directing the first and second (pulsed laser) irradiation may comprises directing the first and second (pulsed laser) irradiation onto a first region of the EUV photolithography mask for a first time period and directing the laser irradiation onto a second region of the EUV photolithography mask for a second time period.

Thereby, a high-resolution modification of the mask and/or the multilayer system may be achieved.

In such process, the mask may, e.g., be scanned region by region such as to repair the mask and/or the multilayer system. E.g., when the third irradiation is provided as well, it may analogously be directed onto the first and/or second region.

For example, the first and/or second (pulsed laser) irradiation comprise a focal size, at a region of the multilayer system, of 100 nm to 10 µm, preferably from 500 nm to 2 µm.

In some examples, the first and/or second (pulsed laser) irradiation may be adapted to allow a δREG control in the EUV photolithography mask with a resolution below 100 µm, preferably below 10µm, particularly preferably below 5 µm. In some examples, the δREG may be controlled with a resolution that essentially corresponds to a spot size of the laser irradiation.

In this size range, relevant modifications may be achieved. This resolution is much better than previous methods, which, e.g., achieved a resolution in the range of hundreds of µm.

A second aspect of the invention relates to a method for treating an EUV photolithography mask comprising a multilayer system and a substrate, the method comprising providing a first (pulsed laser) irradiation, wherein the first (pulsed laser) irradiation comprises a plurality of pulse sequences, each pulse sequence comprising a plurality of pulses; wherein a first pulse and a second pulse of the plurality of pulses are separated by a time of 100 ns or less, providing a third irradiation, directing the first laser irradiation onto and/or into the multilayer system, and directing the third irradiation into the substrate wherein the third irradiation is configured to induce an expansion of the substrate.

Thereby, the invention according to the second aspect combines the high resolution of the first (pulsed laser) irradiation with the essentially zero-δR δREG control via the third radiation.

E.g., the second pulsed laser radiation described herein may be implemented in the second aspect of the invention as well.

Generally, all features described herein may be combined with the first and/or the second aspect of the invention.

Further aspects of the invention relate to an apparatus for (automatically) executing the method described herein and a respective computer program comprising instructions for the steps of the method described herein.

Generally, all features described herein may be implemented as method steps, functionalities of a corresponding apparatus and/or computer program. It is noted that the invention is described herein mainly with reference to multilayer systems of EUV lithography masks. It is noted, however, that it may also be used for other EUV lithography masks with multilayer systems and/or for other objects with multilayer systems, such as wafers, semiconductor substrates etc.

### 4. Description of the figures

Fig. 1 shows an exemplary EUV photolithography mask comprising a multilayer system.
Fig. 2 shows the exemplary EUV photolithography mask of Fig. 1 processed by frontside laser irradiation.
Fig. 3 shows the exemplary EUV photolithography mask of Fig. 1 processed by backside laser irradiation.
Fig. 4 shows a high-resolution transmission electron micrograph of an exemplary multilayer system irradiated with femtosecond laser pulses at a fluence of 280 mJ/cm².
Fig. 5 shows four exemplary reflectance spectra of treated and untreated multilayer systems.
Fig. 6 shows a microscopy image top view of a laser irradiation-treated exemplary multilayer system.
Fig. 7 shows an exemplary depth profile of a laser irradiation-treated exemplary multilayer system acquired by atomic force microscopy and one representative cut through the depth profile.
Fig. 8 shows a schematic representation of light reflection and absorption at different layers of an exemplary multilayer system.
Fig. 9 shows a schematic representation of the absorbed energy distribution in an exemplary multilayer system linked to the physical processes illustrated in Fig. 8.
Fig. 10 shows an exemplary laser irradiation intensity over time, wherein the laser irradiation comprises a sequence comprising a sub-sequence of sub-pulses.
Fig. 11 schematically shows five exemplary ways of controlling a sequence envelope.
Fig. 12 shows an exemplary relative temperature distribution as a function of depth into the multilayer system created upon different temporal pulse sequences.
Fig. 13 shows a schematic comparison of exemplary first and second (pulsed laser) irradiations.
Fig. 14 shows a schematic representation of an exemplary third irradiation and the substrate expansion induced thereby.
Fig. 15 shows a schematic comparison of exemplary first, second, and third (pulsed laser) irradiations.

### 5. Detailed description of preferred embodiments

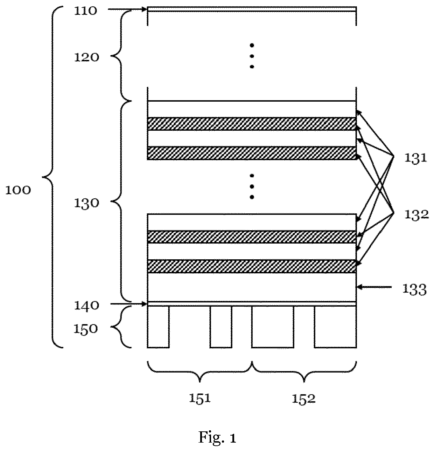

Fig. 1 shows an EUV photolithography mask 100 comprising a multilayer system 130 as one example for an optical element 100 as described herein. The optical element may comprise a layered architecture 100. In the example of Fig. 1, the layers may extend in the horizontal plane. The layers may typically have lateral dimensions in the horizontal plane that extend the thickness in the vertical direction (i.e., the stacking direction of the layers) by many orders of magnitude.

The exemplary optical element 100 comprises a backside coating 110 applied onto a substrate 120. The backside coating may, e.g., comprise TaB and/or have a thickness between 10 nm and 500 nm, preferably between 50 nm and 100 nm. The substrate may, e.g., comprise a low thermal expansion material and/or have a thickness in the mm range, preferably between 1 mm and 10 mm, more preferably between 6 mm and 7 mm. The three dots illustrate that the drawing of Fig. 1 is not scaled but the substrate may be much thicker than shown here.

The optical element 100 may further comprises a multilayer system 130 comprising two alternatingly stacked layers, a first layer 131 and a second layer 132. For example, the first layer 131 and the second layer 132 may comprise materials with different refractive indices. This allows them to form a reflective Bragg mirror, e.g., as described herein. The first layer 131 may, e.g., comprise Si and/or have a thickness of ca. 4.0 nm as shown in the example of Fig. 1**.** The second layer 132 may, e.g., comprise Mo and/or have a thickness of ca. 2.9 nm as shown in the example of Fig. 1**.** Again, the three dots illustrate that the drawing of Fig. 1 is not scaled but the multilayer structure 130 may be much thicker than shown here. Typically, multilayer systems 130 may comprise between 10 and 200 bilayers (e.g., each comprising one first layer 131 and one second layer 132), e.g., resulting in thicknesses of the multilayer system 130 in the nanometer range. The multilayer system may be terminated by a final layer 133. In the example of Fig. 1, the final layer 133 may comprise Si and/or have a thickness that is different from the first and/or second layer 131, 132 and/or may be between 3 nm and 11 nm. Other exemplary optical elements may, e.g., comprise three or more alternating layers.

The optical element 100 may, e.g., further comprise a cap layer 140. The cap layer 140 may, e.g., comprise ruthenium (Ru). The multilayer system 130 may thus be sandwiched between the substrate 120 and the cap layer 140. The cap layer 140 may be attached to the multilayer system 130 on the one side and to an absorber layer 150 on the other side.

The absorber layer 150 may be patterned such as to allow it to be used in a photolithography mask. It may comprise relatively densely packed areas 152 (e.g., areas with 50% surface coverage or more) and less densely packed areas 151 (e.g., areas with less than 50% surface coverage).

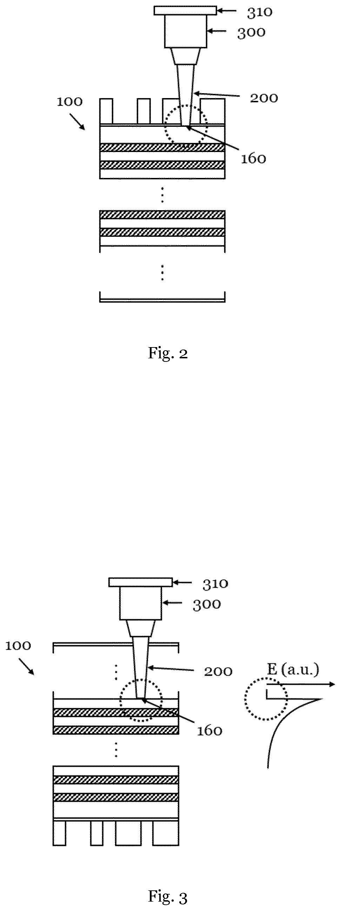

Fig. 2 shows the exemplary optical element 100 of Fig. 1 processed by frontside laser irradiation. Fig. 3 shows the exemplary optical element 100 of Fig. 1 processed by backside laser irradiation. In both cases, a laser source 300 providing the laser irradiation 200 is provided and directs the laser irradiation onto a region 160 of the optical element 100. The energy is absorbed mostly right at the region 160 of the multilayer system that is irradiated by the laser irradiation 200. This is illustrated schematically by the graph on the right of Fig. 3 showing how the deposited energy decreases with increasing depth into the optical element 100. This applies analogously for the scenario of Fig. 2 (frontside irradiation) and 3 (backside irradiation).

The laser source may, e.g., as shown in Figs. 2 and 3, be mounted to a means for moving the laser source 310. The means for moving the laser source 310 may, e.g., comprise a two- and/or three-dimensional stage allowing the laser source to be moved relative to the optical element 100, e.g., in an automized way. This may, e.g., be controlled by an according computer program as described herein.

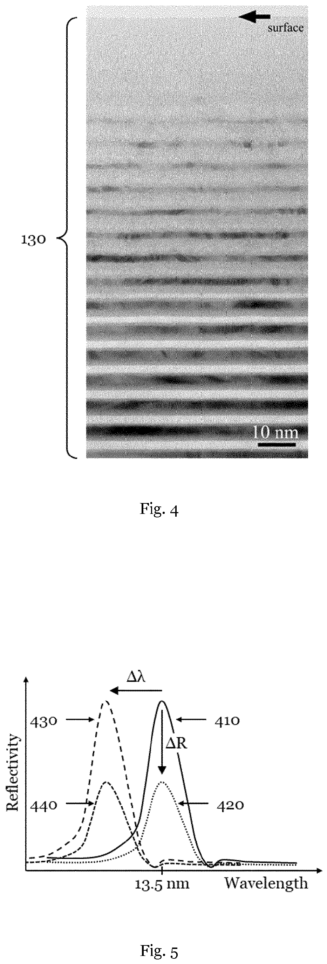

Fig. 4 shows a high-resolution transmission electron micrograph of an exemplary multilayer system 130 irradiated with femtosecond laser pulses at a fluence of 280 mJ/cm². The surface (at the top of Fig. 4) is treated by the laser irradiation (not shown). This treatment resulted in the diminishing of the layers of the multilayer system 130 near the surface while at the bottom, the individual layers are clearly visible as less energy was deposited there.

Fig. 5 shows four exemplary reflectance spectra of treated 420, 430, 440 and untreated optical elements 410.

The first reflectance spectrum 410 corresponds to an untreated optical element. The reflectance spectrum 410 comprises a high amplitude and is centered at around 13.5 nm.

The second reflectance spectrum 420 corresponds to a first treated optical element. The reflectance spectrum 420 comprises a reduced amplitude and is (like the reflectance spectrum 410 of the untreated optical element) centered at around 13.5 nm. This may, e.g., be achieved by the depletion of the layers of a multilayer system as, e.g., shown in Fig. 4. The reflectance spectrum 410 of the untreated optical element and the reflectance spectrum 420 of the first treated optical element thus essentially differ by an amplitude difference ΔR.

The third reflectance spectrum 430 corresponds to a second treated optical element. The reflectance spectrum 430 comprises essentially the same amplitude (like the reflectance spectrum 410 of the untreated optical element) and is centered at around a wavelength shorter than 13.5 nm. This may, e.g., be achieved by compaction of the layers of the layers of a multilayer system. The reflectance spectrum 410 of the untreated optical element and the reflectance spectrum 430 of the second treated optical element thus essentially differ by a wavelength shift Δλ.

The fourth reflectance spectrum 440 corresponds to a third treated optical element. The reflectance spectrum 440 comprises a reduced amplitude (e.g., achieved by the depletion of the layers) Further, it is centered at around a wavelength shorter than 13.5 nm. (e.g., achieved by compaction of the layers). The reflectance spectrum 410 of the untreated optical element and the reflectance spectrum 440 of the third treated optical element thus essentially differ by an amplitude difference ΔR and a wavelength shift Δλ.

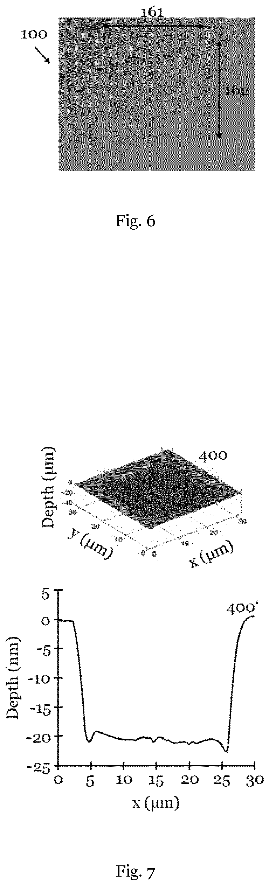

Fig. 6 shows a microscopy image top view of a laser irradiation-treated optical element 100 comprising a multilayer system acquired by optical microscopy. The treated area may be perceived as a square-shaped area with border lengths 161, 162 of ca. 20 µm each.

Fig. 7 shows an exemplary atomic force microscopy depth profile 400 of a laser irradiation-treated optical element 100 comprising a multilayer system acquired by atomic force microscopy and one representative cut 400' through the depth profile. The cut 400' illustrates the effect of compaction: the depth of the optical element within the treated area differs by ca. 20 nm from the untreated area.

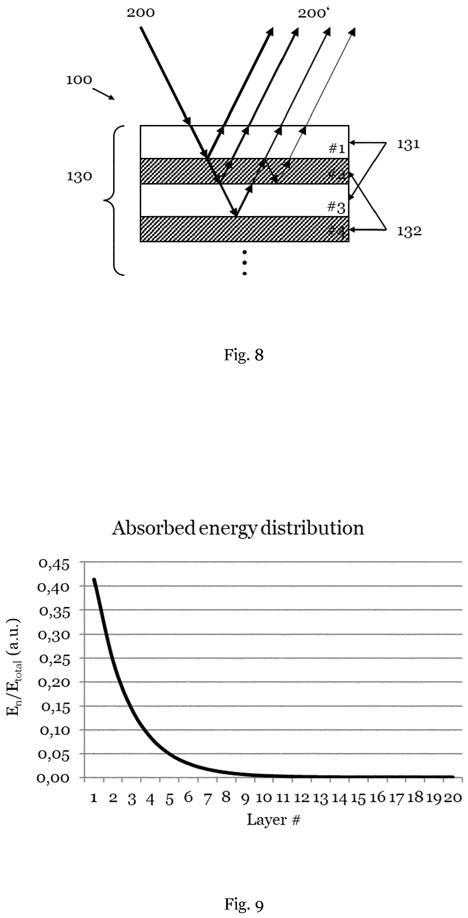

Fig. 8 shows a schematic representation of light reflection and absorption at different layers of an exemplary multilayer system 130 of an optical element 100. An exemplary Mo-Si multilayer system 130 of the optical element 100 may be characterized as shown in Table 2.

**Table 2**

| | h (nm) | n | k | z (µm) | ρ (g/cm³) | C (J/gK) | Tₘ (°C) |
|---|---|---|---|---|---|---|---|
| Mo | 2.9 | 3.6371 | 3.365 | 0.0189 | 10.2 | 0.251 | 2623 |
| Si | 4.0 | 3.681 | 0.005 | 12.7324 | 2.329 | 0.7 | 1412 |
| Qz | | 1.4534 | 0 | | | | |

Table 2 relates to the thickness h, the index of refraction n (for 800 nm irradiation), the extinction coefficient k (for 800 nm irradiation), the penetration depth, at which light intensity drops e-times z, the density ρ, the heat capacity C, and the melting temperature Tₘ of the respective material. At 800 nm, Mo 132 absorbed light much more efficiently than Si 131. Following the equation for extinction (~exp(-kz/λ)), the Mo layer practically absorb almost all the energy. The reflectivity at the Mo-Si interface at 800 nm is ca. 0.174.

In result, the intensity of light decreases the deeper the incoming laser irradiation 200 penetrates the optical element 130. The reflected light 200' thus is also weaker, the deeper the interface it is reflected by. The underlying reason for this depth-dependence of the light intensity is the absorption by the Mo- 132 and Si-layers 131.

Fig. 9 shows a schematic representation of the absorbed energy distribution in an exemplary multilayer system linked to the physical processes illustrated in Fig. 8.

While the first Mo-layer absorbs ca. 40% of the incoming energy, this ration drops to less than 25% for the second Mo-layer, less than 15% for the third Mo-layer and so on. The absorption by the Si-layers may be neglected in this model (cf. Table 2).

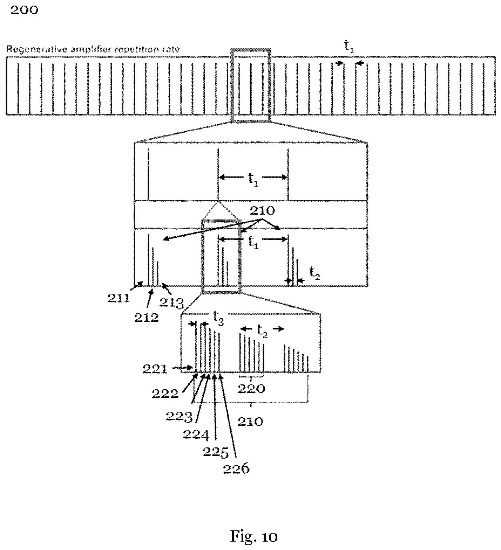

The aspects described herein in reference to Figs. 10 to 12 may particularly apply to the first (pulsed laser) irradiation described herein.

Fig. 10 shows an exemplary laser irradiation intensity over time, wherein the laser irradiation 200 comprises a sequence 210 comprising pulses 211, 212, 213. The time t₁ is the time between two consecutive (pulse) sequences 210 and the time t₂ is the time between two consecutive pulses 211, 212, 213. Optionally, each (or at least one) of the pulses 211, 212, 213 may comprise a sub-sequence 220 comprising a plurality of sub-pulses 221, 222, 223, 224, 225, 226. Time t₃ is the time between two consecutive sub-sequences 220.

In the example of Fig. 10, the envelope of the sequence 210 as well as of the optional sub-sequences is controlled to monotonically decrease the intensity of the pulses within each sequence 210 and within each sub-sequence 220.

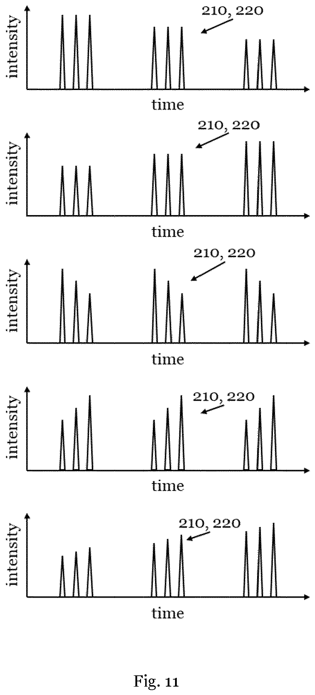

Fig. 11 schematically shows five exemplary ways of controlling the sequence envelope. The shown concept may analogously apply to an envelope control of a sequence 210 and/or a sub-sequence 220 as described herein.

The first panel shows that the intensity for all pulses is constant within a (sub-) sequence 210, 220 but decreases monotonically for the next (sub-)sequence(s) 210, 220.

The second panel shows that the intensity for all pulses is constant within a (sub-) sequence 210, 220 but increases monotonically for the next (sub-)sequence(s) 210, 220.

The third panel shows that the intensity decreases monotonically within a (sub-) sequence 210, 220 wherein subsequent (sub-)sequences 210, 220 have the same envelope.

The fourth panel shows that the intensity increases monotonically within a (sub-) sequence 210, 220 wherein subsequent (sub-)sequences 210, 220 have the same envelope.

The fifth panel shows that the intensity increases monotonically within a (sub-) sequence 210, 220 and increases monotonically across subsequent (sub-)sequences 210, 220 for a predetermined number of subsequent (sub-)sequences 210, 220 (in this example three).

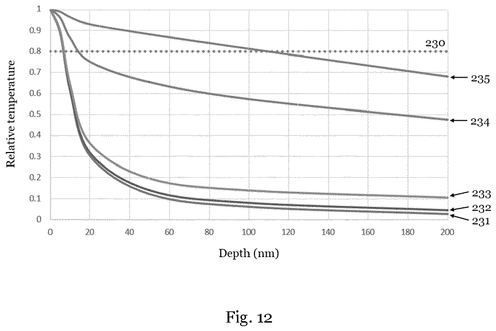

Fig. 12 shows exemplary relative temperature distributions 231, 232, 233, 234, 235 as a function of depth into the multilayer system created upon different temporal pulse sequences 210 and/or sub-sequences 220. Further, Fig. 12 shows a reference threshold 230 of 80% of the temperature at the irradiated surface of the treated optical element.

The first exemplary relative temperature distributions 231 may, e.g., be induced by single pulse irradiation (i.e., laser irradiation comprising no pulse sequence). It can be seen that all further irradiations result in improved relative temperature distributions 232, 233, 234, 235.

The second exemplary relative temperature distributions 232 may, e.g., be induced by a laser irradiation comprising a pulse sequence comprising two pulses separated by a time of 25 ns.

The third exemplary relative temperature distributions 233 may, e.g., be induced by a laser irradiation comprising a pulse sequence comprising ten pulses, wherein consecutive pulses are separated by a time of 25 ns.

The fourth exemplary relative temperature distributions 234 may, e.g., be induced by a laser irradiation comprising a pulse sequence comprising ten pulses, wherein consecutive pulses are separated by a time of 16 ns. Further, each pulse comprises a sub-sequence of ten sub-pulses, wherein consecutive sub-pulses are separated by a time of 0.4 ns.

The fifth exemplary relative temperature distributions 235 may, e.g., be induced by a laser irradiation comprising a pulse sequence comprising ten pulses, wherein consecutive pulses are separated by a time of 16 ns. Further, each pulse comprises a sub-sequence of ten sub-pulses, wherein consecutive sub-pulses are separated by a time of 0.4 ns. Additionally (and in contrast to the fourth exemplary relative temperature distribution 234), the intensity of the sub-pulses fades by 10% (of the intensity of the first sub-pulse of the sub-sequence) between consecutive pulses within the sub-sequence (i.e., a monotonically decreasing intensity throughout the sub-sequence).

Interestingly, one can see that the different aspects of the invention like adjusting the sequence duration, the time between pulses, and/or the envelope control may substantially improve the result achieved by the methods allowing to reach a more evenly distributed temperature throughout the treated optical element. The results are summarized in Table 3.

One can see that gradually the temperature distribution increases from example #1 to example #5 from Fig. 12. This may be quantified, e.g., by means of the ration between the temperature at 200 depth and the temperature at the surface, i.e., 0 nm depth (T_{200 nm} / T_{0 nm}) or the depth at which the temperature drops to 80% of the temperature at the surface d_{80%}. Both measures are significantly increasing with the measures taken by examples #2 - #5 compared to the reference example #1.

**Table 3**

| Example | n₁ | t₁ (ns) | n₂ | t₁ (ns) | Envelope | T_{200 nm /} T_{0 nm} | d_{80%} (nm) |
|---|---|---|---|---|---|---|---|
| #1 (231) | 1 | - | - | - | - | 2.6 % | 5 |
| #2 (232) | 2 | 25 | - | - | - | 4.3 % | 6 |
| #3 (233) | 10 | 25 | - | - | - | 11 % | 8 |
| #4 (234) | 10 | 16 | 10 | 0.4 | - | 47 % | 13 |
| #5 (235) | 10 | 16 | 10 | 0.4 | yes | 68 % | 108 |

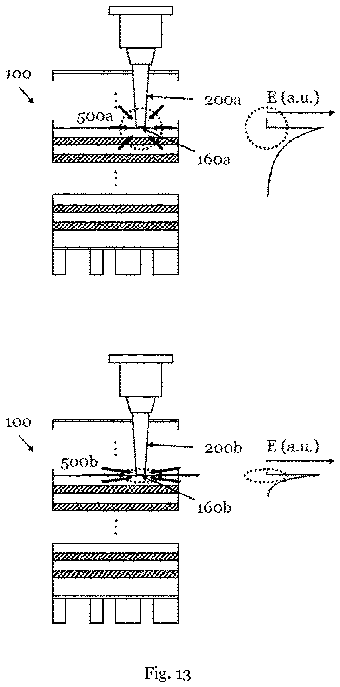

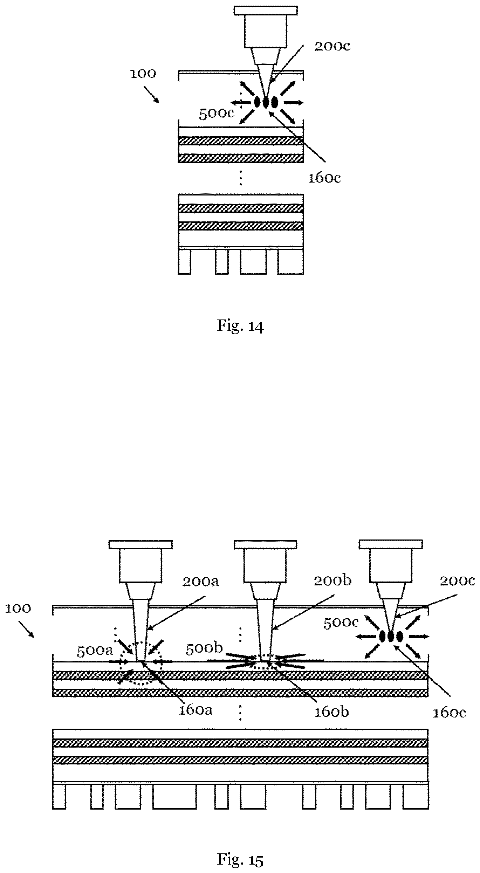

Figs. 13 and 14 separately show schematic representations of the first, second, and third (pulsed laser) irradiations 200a, 200b, 200c:
Fig. 13 shows a schematic comparison of exemplary first and second (pulsed laser) irradiations 200a, 200b. In the top panel, it is shown how the first (pulsed laser) irradiation 200a is directed onto the multilayer system of the photolithography mask 100. In general, the process is as described in reference to Fig. 3: A laser source providing the laser irradiation 200a, 200b directs the laser irradiation 200a, 200b onto a region 160a, 160b of the EUV photolithography mask 100. The energy is absorbed mostly right at the region 160a, 160b of the multilayer system that is irradiated by the laser irradiation 200a, 200b. This is illustrated schematically by the graph on the right showing how the deposited energy decreases with increasing depth into the EUV photolithography mask 100. It can be seen that the first irradiation 200a (top panel) penetrates the multilayer system deeper than the second irradiation 200b (bottom panel). Analogously, as illustrated by the bold arrows around the region of incidence 160a, 160b strain 500a, 500b (registration δREG) is created in the treated regions, which may be stronger for the second irradiation 200b than for the first irradiation 200a for the same induced δR.

Fig. 14 shows a schematic representation of an exemplary third irradiation 200c and the substrate expansion 500c induced thereby. The third irradiation is focused into the substrate and induces an expansion of the material in the focus region 160c. The expansion 500c is illustrated by the bold arrows. As it can be seen from the comparison with Fig. 13, said expansion 500c may balance the strain induced by the first and/or second (pulsed laser) irradiation illustrated Fig. 13.

Fig. 15 shows a schematic representation of exemplary first, second, and third (pulsed laser) irradiations 200a, 200b, 200c, i.e., essentially a combination of what is shown in Figs. 13 and 14. It is shown how the three irradiations 200a, 200b, 200c induce different effects 500a, 500b, 500c in the EUV photolithography mask 100 (e.g., as outlined in reference to Figs. 13 and 14) at the respective region of incidence 160a, 160b, 160c.

## Claims

1. Method for treating a multilayer system of an extreme ultraviolet (EUV) photolithography mask, the method comprising:
providing a first irradiation with at least one first pulse parameter;
providing a second irradiation with at least one second pulse parameter; and
directing the first irradiation and the second irradiation into and/or onto the multilayer system;
wherein the first irradiation and the second irradiation differ in a reflectivity change (δR) / registration change (δREG) ratio induced in the EUV photolithography mask.

2. The method of claim 1, wherein the first irradiation comprises a high δR/δREG ratio, preferably in the range from 0.2% to 1% reflectivity drop per ppm registration change; and the second irradiation comprises a low δR/δREG ratio, preferably below 0.2% reflectivity drop per ppm registration change.

3. The method of claim 1 or 2, wherein the first irradiation comprises:
a plurality of pulse sequences, each pulse sequence comprising a plurality of pulses; wherein a first pulse and a second pulse of the plurality of pulses are separated by a time of 100 ns or less and/or;
the second irradiation comprises an essentially continuous pulse train.

4. The method of claim 3, wherein the first pulse and the second pulse of the plurality of pulses are separated by a time of at least 10 ns.

5. The method of claim 3 or 4, wherein the pulses of the plurality of pulses are repeated at a frequency of 10 MHz to 1 GHz.

6. The method of any of claims 3-5, wherein at least one of the pulses comprises at least one sub-sequence comprising a plurality of sub-pulses; wherein a first sub-pulse and a second sub-pulse of the plurality of sub-pulses are separated by a time between 1 ps and 100 ns, wherein preferably the sub-pulses of the plurality of sub-pulses are repeated at a frequency of 1 GHz to 100 GHz, preferably of 1 GHz to 10 GHz.

7. The method of any of the preceding claims, wherein the first irradiation is adapted to substantially locally change at least two layers of the multilayer system; and/or wherein the first irradiation comprises a temporal pulse pattern.

8. The method of any of the preceding claims, wherein
a wavelength of the first and/or second irradiation is between 400 and 1500 nm, preferably between 700 nm and 1100 nm;
the repetition rate of the first and/or second irradiation is between 1 kHz and 1 MHz, preferably between 50 kHz and 200 kHz;
a laser pulse length of the first and/or second irradiation is in the femtosecond range, preferably between 10 fs and 1000 fs, more preferably between 80 fs and 300 fs;
a pulse energy of the first and/or second irradiation is between 0,05 µJ to 5 µJ; and/or
a pulse density of the first and/or second irradiation is between 1,000 pulses per mm² to 10,000,000 pulses per mm².

9. The method of any of the preceding claims, further comprising:
providing a third laser irradiation; and
directing the third laser irradiation onto and/or into the substrate, wherein the third laser irradiation is configured to induce an expansion of the substrate.

10. The method of claim 9, further comprising controlling the third laser irradiation such that the EUV photolithography mask is processed to be substantially flat.

11. The method of any of the preceding claims, further comprising controlling the first and/or the second irradiation such that for a target overall δR, an overall induced δREG lies within a predetermined range.

12. The method of any of the preceding claims, wherein the multilayer system comprises a frontside and a backside;
wherein, optionally, the EUV photolithography mask comprises an absorber layer at the frontside and/or a substrate on the backside; and
wherein the directing the first and second irradiation onto and/or into the multilayer system comprises directing the first and/or second irradiation onto the backside of the multilayer system.

13. The method of any of the preceding claims, wherein the directing the first and second irradiation comprises:
directing the first and second irradiation onto a first region of the EUV photolithography mask for a first time period; and
directing the laser irradiation onto a second region of the EUV photolithography mask for a second time period.

14. The method of any of the preceding claims, wherein the first and/or second irradiation comprise a focal size, at a region of the multilayer system, of 500 nm to 100 µm, preferably from 1 µm to 20 µm.

15. The method of any of the preceding claims, wherein the first and/or second irradiation is adapted to allow a registration change (δREG) control in the EUV photolithography mask with a resolution below 100 µm, preferably below 10µm, particularly preferably below 5 µm.

16. A method for treating an extreme ultraviolet (EUV) photolithography mask comprising a multilayer system and a substrate, the method comprising:
providing a first irradiation, wherein the first irradiation comprises:
a plurality of pulse sequences, each pulse sequence comprising a plurality of pulses; wherein a first pulse and a second pulse of the plurality of pulses are separated by a time of 100 ns or less;
providing a third irradiation;
directing the first laser irradiation onto and/or into the multilayer system; and
directing the third irradiation into the substrate wherein the third irradiation is configured to induce an expansion of the substrate.
